Europäisches Patentamt

(19) European Patent Office

Office européen des brevets

(11) Publication number: **0 285 625 B1**

(12) **EUROPEAN PATENT SPECIFICATION**

(45) Date of publication of patent specification:
26.06.91 Bulletin 91/26

(51) Int. Cl.⁵: **C23C 14/32, C23C 14/22**

(21) Application number: 87906260.2

(22) Date of filing: 08.09.87

(86) International application number:
PCT/US87/02252

(87) International publication number:
WO 88/02790 21.04.88 Gazette 88/09

(54) PROCESS AND APPARATUS FOR FILM DEPOSITION UTILIZING VOLATILE CLUSTERS.

(30) Priority: 15.10.86 US 919096

(43) Date of publication of application:
12.10.88 Bulletin 88/41

(45) Publication of the grant of the patent:
26.06.91 Bulletin 91/26

(84) Designated Contracting States:
DE FR GB NL

(56) References cited:
EP-A- 0 061 906
EP-A- 0 141 417

(56) References cited:
N.T.I.S. Technical Notes, no. 8, part G, August 1986, Springfield, Virginia, US; D.J. Fitzgerald et al.: "Improvements in ionised cluster-beam deposition", page 987

(73) Proprietor: Hughes Aircraft Company
7200 Hughes Terrace P.O. Box 45066
Los Angeles, California 90045-0066 (US)

(72) Inventor: KNAUER, Wolfgang
5520 Horizon Drive
Malibu, CA 90265 (US)

(74) Representative: Kuhnen, Wacker & Partner
Schneggstrasse 3-5 Postfach 1553
W-8050 Freising (DE)

## Description

This invention relates to a process and an apparatus for vapor depositing a film upon a substrate, and, more particularly, to the deposition of a thin film.

The deposition of thin films upon substrates is an important manufacturing and research tool in a variety of fields. For example, microelectronic devices are prepared by depositing successive film layers onto a substrate to obtain specific electronic properties of the composite. Photosensitive devices such as vidicons and solar cells are manufactured by depositing films of photosensitive materials onto substrates. Optical properties of lenses are improved by depositing films onto their surfaces. These examples are, of course, only illustrative of the thousands of applications of thin film deposition techniques.

In the highly controlled approach to thin-film deposition that is characteristic of applications where a high quality film is required, the film is built up by successive deposition of monolayers of the film, each layer being one atom thick. The mechanics of the deposition process can best be considered in atomistic terms. Generally, in such a process the surface of the substrate must be carefully cleaned, since minor contaminant masses or even contaminant atoms can significantly impede the deposition of the desired highly perfect film. The material of the film is then deposited by one of many techniques developed for various applications, such as vapor deposition, sputtering, or chemical vapor deposition, to name a few.

Cleaning of the surface prior to deposition of the film is accomplished by mechanical and chemical means, and sometimes by an ion or electron bombardment technique. In the latter approach, ions or electrons are impacted upon the surface to dislodge contaminants prior to deposition of the film. The deposition technique can sometimes have an associated cleaning effect on the substrate surface. In sputtering, for example, highly energetic atoms of the sputtering gas may contact the surface to remove contamination even as deposition proceeds, but can also damage the substrate target by inducing point defects.

Cleaning of the surface during deposition of the film is beneficial in preventing formation of in situ contamination. However, cleaning by ions during deposition is difficult, since space charge effects prevent ions from reaching the surface, or at the least reduce their effectiveness in removing contamination.

To avoid the space charge effects and permit cleaning of the surface as deposition is proceeding, it has been previously known to accelerate ions or atoms against the surface with sufficiently high velocities that they penetrate to the surface with high energies. Cleaning is accomplished by such procedures, but typically the energy carried by each ion or atom is so high that collisions at the surface create point defects in the substrate target. These point defects then cause nucleation of growth irregularities as each monolayer of the film develops, so that the film contains a much greater defect density than typical for films wherein no simultaneous cleaning is undertaken.

Another problem with some deposition techniques is that the deposited material may not be uniformly spaced over the surface of the substrate, with the result that the addition of material does not occur by monolayer growth. Instead, the growth is irregular, with some areas growing in thickness faster than others. The result is an irregular surface that is not acceptable for some applications. Irregular growth also leads to defects in the layer, which can adversely affect the electrical characteristics of the film, and the ability to deposit further overlying layers.

The substrate is often heated to increase the mobility of the deposited material on the surface, so that the tendency to form irregularities is reduced. Heating the substrate has the disadvantage that boundaries and composition gradients between previously deposited layers are degraded, interfering with the electrical junction characteristics. A high kinetic energy of the deposited ions or atoms contributes to the regularity of the layer by moving the deposited material about on the surface, but, as previously discussed, the high energy typically introduces defects into the surface.

Thus, there is a continuing need for improvements to the deposition process whereby the surface of the substrate upon which the film is deposited can be accomplished during deposition. There is the further need for improving the uniformity of the layer as it is deposited. The present invention fulfills this need, and further provides related advantages.

From EP 0 061 906 A1, a method and an apparatus for processing (plating, diffusion, etching or milling) a workpiece with energetic particles of atomic or molecular size is known. A plurality of beams of such particles obtained from different source substances are impinged jointly on the workpiece. The plural beams of ions, or parallel produced beams of ions and beams of neutral particles are applied simultaneously or succesively on the workpiece. The beam of particles is pulsed to produce a cluster thereof, containing the particles therein ranging between 100 and 1000 in number. Different and parallel produced beams are focused to form a unitary composite beam in which different energetic particles are mixed together prior to impingement on the workpiece.

In NTIS Technical Notes, No. 8, part G, August 1986, page 987, improvements in ionized cluster-beam deposition are disclosed. In particular, it is suggested to use gaseous compounds in forming a cluster beam by adiabatic expansion into a vacuum, thereby lowering the temperature to around 200 to 300 K.

## SUMMARY OF THE INVENTION

The present invention as defined in Claims 1 and 11 resides in a process and apparatus for depositing a film layer onto a substrate. The substrate is effectively cleaned by an ionic bombardment of sufficient kinetic energy to penetrate the surface space charge, but not sufficient to introduce a high defect density into the layer as it grows. The kinetic energy of the ionic bombardment also energizes the deposited material to promote its movement on the surface and thence improve the uniformity of the layer as it grows. Less thermal energy is required, so that the substrate can be held to a lower temperature than normal, with the result that the previously deposited structure is retained with little degradation. The ionic bombardment can be selected so that it does not chemically react with the deposited material, acting only as an energy carrier. Alternatively, the ionic bombardment can be selected to react with the deposited material to form a reaction product such as a compound or complex on the surface.

In accordance with the invention, a process for vapor depositing a film upon a substrate comprises the steps of depositing a nonvalatile material upon the substrate by vaporizing said material using a vapor source, and, simultaneously, directing a beam of ionized clusters of a volatile species against the substrate, each cluster having from 2 to about 10000 atoms.

As used herein, a cluster is a weakly bound assembly of atoms, typically formed by condensation with homogeneous or heterogeneous nucleation of the cluster. The cluster is weakly ionized, as by electron bombardment, so that the cluster is singly ionized or at most carries a few ionic charges. That is, each individual atom of the cluster is not ionized, but perhaps only one or a few electrons are removed from the entire cluster. The cluster is accelerated toward the substrate by an accelerating potential. Because of the high cluster mass, typically 1000 times that of a single atom, the resulting cluster beam is not dispersed by its own space charge.

When the cluster impacts upon the surface of the substrate target, it immediately disintegrates. Each atom has a small energy, equal to the total energy of the cluster divided by the number of atoms in the cluster, so that little damage is done to the surface and few defects are introduced. The atoms of the cluster have sufficient energy to dislodge contaminants on the surface, thereby cleaning the surface simultaneously with deposition. The atoms produced by the disintegration of the cluster also have sufficient energy to energize the nonvolatile material to move on the surface. The movement of the nonvolatile atoms increases the uniformity of the deposited layer with much the same result as if the surface were heated to a much higher temperature than necessary with the present process. The previously deposited layers are not heated, however, so that the structure already deposited and buried inside the structure is not disturbed.

The species of the cluster is termed a volatile species, since these atoms are free to leave the surface of the substrate after their kinetic energy transfer function is complete. In contrast, the nonvolatile material remains on the surface as the deposited layer. The volatile species may be a noble gas such as argon. The volatile species may also be a reactive species such as oxygen, nitrogen or an organic molecule, which can react with selected nonvolatile materials to form reaction products on the surface. An example is the use of oxygen as the volatile species and silicon as the nonvolatile species, with $SiO_2$ deposited on the surface as the reaction product. The excess oxygen atoms above those required for stoichiometric combination are volatile and leave the surface after their energy transfer is complete. This variation, wherein some of the volatile atoms remain on the surface in combination with the deposited material while others leave the surface, is within the scope of the term volatile as used herein.

Each cluster has 2 to about 10000 atoms. More preferably, the clusters are of the larger size and have about 1000 to about 10000 atoms. Most preferably, the clusters are of about the same size and contain about 1000 atoms. The accelerating voltage is selected so that the energy of each atom of the cluster is from about 1 to about 5 electron volts. If, for example, the size of the clusters were 1000 atoms each, and the desired energy of each atom of the volatile species after reaching the surface of the substrate were 2 electron volts, the accelerating voltage would be selected as 2000 volts.

In some situations, the clusters are directed toward the substrate in a pulsed fashion. That is, clusters are passed to the substrate for a period of time, and then no clusters are passed for a period of time. As an example, clusters may be passed to the substrate for 2 milliseconds out of every 100 milliseconds. The duty cycle is therefore 2 milliseconds on, 98 milliseconds off, followed by a repetition.

In many applications, it has been found that good results are obtained if a ratio of one cluster atom for each atom of nonvolatile material deposited is maintained. If the source of the volatile clusters is operated continuously, the flow of volatile clusters would likely exceed the number needed to maintain this ratio. Continuous operation of the source of volatile clusters also creates a high gas pressure adjacent the substrate as the volatile gases leave the surface, which demands high levels of pumping.

The substrates with thin films deposited thereon made by the present invention have unique properties. The combination of low contamination and low defect density of the films, together with excellent adhesion to the substrate, low internal stress, and excellent surface smoothness, cannot be attained otherwise.

Also in accordance with the invention, apparatus for vapor depositing a film upon a substrate located in the apparatus comprises a vapor source of a nonvolatile material vapor disposed to deposit the nonvolatile material onto the substrate, and means for directing clusters of a volatile species against the substrate simultaneously with deposition from the vapor source, each cluster having from 2 to about 10000 atoms.

The first source of the nonvolatile material may be any of several conventional types of sources, such as a crucible-type vapor source or an electron beam-type vapor source, or a sputtering source. The means for directing clusters preferably produces ionized clusters that are accelerated toward the surface. The source of the clusters is designed to produce the clusters by homogeneous or heterogeneous nucleation and growth. One acceptable type of source of the clusters includes a supersonic nozzle wherein gas atoms condense to clusters as they pass through the nozzle.

It will now be appreciated that the present invention represents a significant advance in the art of thin film deposition. Ionized clusters are used to remove contaminants from the surface as deposition proceeds, without introducing unacceptably high defect levels into the film. The massive clusters pass to the surface unimpeded by space charge and then disintegrate as they impact the surface. The individual atoms of the cluster have sufficient energy to drive contaminants from the surface, and also to energize the nonvolatile atoms on the surface to produce a more uniform surface. The substrate need not be heated to as high a temperature as would be required in the absence of the use of volatile clusters, resulting in less thermal degradation of previously deposited film layers : Because the volatile clusters and the nonvolatile material are produced from different sources, there is a great deal of flexibility to choose operating parameters to optimize the deposition performance of the system. Other features and advantages of the present invention will be apparent from the following more detailed description of the preferred embodiment, taken in conjunction with the accompanying drawings, which illustrate, by way of example, the principles of the invention.

BRIEF DESCRIPTION OF THE DRAWINGS

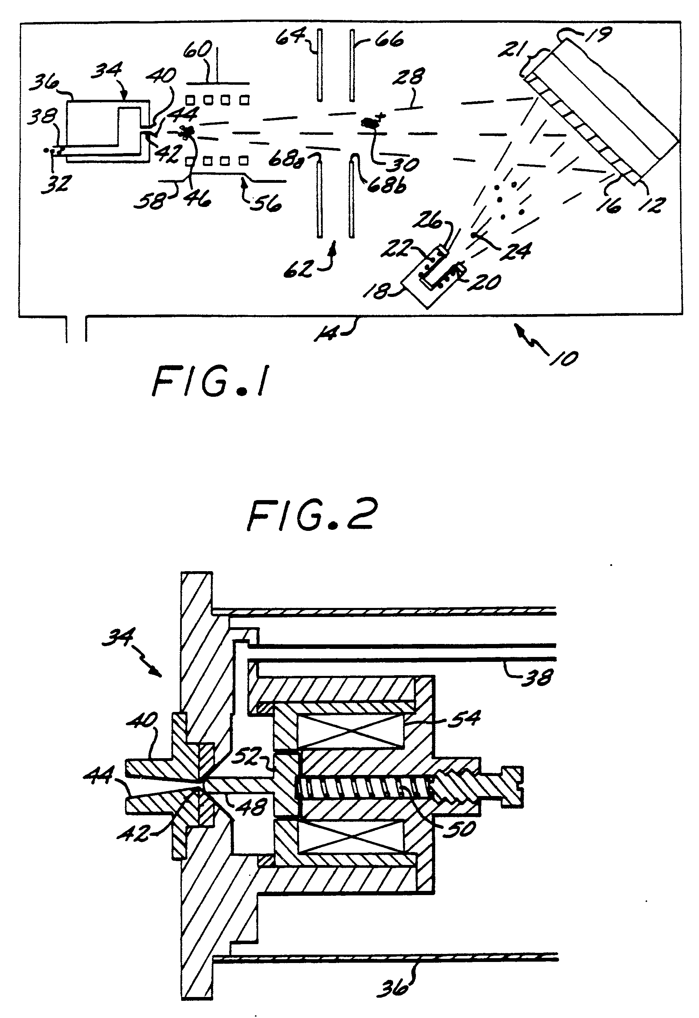

Figure 1 is a schematic illustration of a deposition apparatus in accordance with the invention ; and Figure 2 is a side sectional view of a pulsed cluster source. ·

DETAILED DESCRIPTION OF THE PREFERRED EMBODIMENT

Figure 1 schematically depicts a preferred deposition apparatus 10. A substrate 12 is mounted in a vacuum chamber 14 so that a surface 16 of the substrate 12 faces a vapor source 18. It is understood that, as used herein, the substrate 12 is the piece upon which deposition is occurring at any moment, and typically includes a deposition base 19 and all previously deposited material 21 upon that base 19. That is, the thickness of the substrate 12 is constantly increasing during deposition.

The vapor source 18 can be of any type, but is here shown as the preferred thermal source type where a material to be evaporated is placed into a crucible 20 within a heating coil 22. The coil 22 is heated by an electric current to cause nonvolatile vapor atoms 24 to evaporate. The vapor atoms 24 escape through a collimating orifice 26 in the vapor source 18, travel through the vacuum, and impact upon the surface 16 of the substrate 12. A great variety of materials may be deposited by this technique. Illustrative examples include gold, aluminum, silicon, gallium jointly with arsenic (from two sources 18 operating simultaneously), and nonmetallics, but the invention is not limited to use of these materials. Materials which cannot be deposited by a thermal vapor source 18, tungsten, for example, can be deposited by other means, such as electron beam vapor deposition or chemical vapor deposition, which can be made compatible with the use of ionized volatile clusters. The present invention is not limited by the type of the nonvolatile material or the source of the nonvolatile material.

A beam 28 of ionized clusters 30 of a volatile species 32 is directed against the surface 16 of the substrate 12, simultaneously with the deposition of vapor atoms 24 from the vapor source 18. The clusters comprise from 2 to about 10,000 atoms, and disintegrate readily upon impact, an important feature.

The clusters 30 of the volatile species 32 are produced in a pulsed cluster source 34, which is more fully illustrated in Figure 2. The pulsed cluster souce 34 includes a hollow body 36 which is pressurized by a gas line 38. The gas is ejected through a supersonic nozzle 40, typically having a diameter of a narrow throat 42 of about .020 inches (= 0,508mm). The maximum exit diameter of an expansion section 44, through which the gas expands after leaving the throat 42, is larger than that of the throat 42, and is typically about one-quarter of an inch (= 6,35 mm). The ejected gas expands isentropically through the supersonic nozzle 40 and groups of the atoms of the volatile species 32 condense to form volatile clusters 46. As the gas expands, it cools and becomes supersaturated, leading to homogeneous nucleation of small clusters in the gas stream. Nucleation can also occur at the walls of the pulsed cluster source 34 by heterogeneous nucleation.

The cluster source 34 produces unclustered atoms, small clusters, and large clusters, collectively termed particles herein. The number of atoms in the clusters 46 is determined by several factors, including the expansion ratio, defined as the ratio of the maximum cross sectional area of the expansion section 44 to that of the throat 42, the length of the expansion section 44 along which the gas travels, the gas pressure and temperature in the body 36, and the type of gas. Although it is desirable that the clusters 46 produced by the pulsed cluster source 34 be uniform in size and number of atoms therein, there is some spread in sizes. Indeed, some of the ejected gas never forms into clusters and is ejected as unclustered gas atoms. While undesirable, the spread in size of the clusters 46 and the presence of the unclustered gas atoms does not defeat the purpose of the cluster source 34.

The cluster source 34 can be made to eject the clusters 46 in a pulsing or discontinuous manner by providing a valve plunger 48 that closes the supersonic nozzle 40, at a location just upstream of the throat 42. The valve plunger 48 is held normally closed by a coil spring 50 reacting against the stem 52 of the valve plunger 48. The valve plunger 48 is then moved to the open position by an electromagnetic valve actuator 54. The valve actuator 54 creates a magnetic field when an electrical current is applied, and the magnetic field causes the stem 52 to move within the field.

With this mechanical structure, the valve plunger 48 can be made to open and close rapidly, so that bursts or pulses of gas are emitted through the supersonic nozzle 40. The duty cycle, or periods in which gas is passed out of the cluster source 34 and then not passed, is selected and controlled in accordance with the amount of volatile species to be directed against the substrate 12, which is usually determined relative to the amount of the vapor atoms 24 arriving at the surface. Other factors include the chemical character of, and reactivity with, the vapor atoms 24, the surface area of the substrate 12, the pumping capacity of the deposition apparatus 10, and possibly other considerations in specific situations.

The unionized clusters 46 are generally well collimated upon exiting the supersonic nozzle 40. The clusters enter an ionizer 56, wherein many clusters are positively ionized by electron bombardment, so that the clusters can then be accelerated toward the substrate 12. In the ionizer 56, electrons are emitted from a cathode 58 toward an anode 60 under a positive potential of from about 50 to about 100 volts and with a current of about 10 to about 30 milliamps. The path of the electrons is transverse to and intercepting the line of flight of the previously unionized volatile clusters 46. Some of the electrons hit some of the particles, and the particles become positively charged. It is therefore convenient to consider the cluster itself to be charged, and to continue to speak of atoms, rather than ions, comprising the cluster. The low level of ionization is required so that the cluster may be controllably accelerated toward the substrate 12.

The ionized clusters 30 are accelerated toward the substrate 12 by an electrostatic accelerator 62, wherein a first apertured electrode 64 is maintained at a potential less negative than a second apertured electrode 66. The ionized clusters 30 pass through apertures 68a and 68b of the electrodes 64 and 66, respectively, and are accelerated by the potential difference. The second apertured electrode 66 is typically about 1000 to about 10000 volts more negative than the first apertured electrode 64, which is permitted to float at the same voltage as the ionizer 56. When a singly charged cluster of 1000 atoms passes through the electrodes 64 and 66 maintained at a voltage difference of 1000 volts, an energy of 1000 electron volts is imparted to the cluster 30. This high energy and the high mass of the cluster permit the cluster to penetrate to the surface 16 of the substrate 12. Upon impact the cluster 30 disintegrates, leaving each atom of the cluster with the comparatively small energy of about 1 electron volt. The small energy per atom does not permit the atoms to penetrate the surface 16 of the substrate 12, or otherwise damage the surface and growing thin film. On the other hand, energies per atom on the order of about 1 electron volt aid in promoting a uniform surface structure of the film.

In the preferred embodiment using the apparatus just described, gold is deposited as the vapor atoms 24, and the volatile species 32 is argon. In this embodiment, the gas pressure is about 30 pounds per square inch $(= 2,07 \cdot 10^5 \text{ Pa})$ in the pulsed cluster source 34. The diameter of the throat 42 is 0.010 inches $(= 0,254 \text{ mm})$, and the maximum diameter of the expansion section 44 is 0.200 inches $(= 5,08 \text{ mm})$. The pulsed cluster source 34 is operated at ambient temperature. The repetitive duty cycle of the pulsing is 2 milliseconds on, 98 milliseconds off, thereby producing a discontinuous, pulsed beam of clustered atoms. The current of the ionizer 56 is 10 milliamperes. The voltage applied to the second electrode 66 is negative 5000 volts, while the first electrode 64 is at ground. The substrate 12 is maintained at ambient temperature. The vapor source 18 includes a graphite crucible 20 filled with gold and heated to a temperature of about 1800°C by an electric current passing through the heating coil 22.

The clusters 30 are each a loosely bound collection of atoms of the volatile species 32. The binding energy of each atom of the cluster is typically about 0.1 electron volt. The large mass of each ionized cluster 30 provides a high inertia to the cluster, so that the clusters and cluster beam are not spread out by their own space charge before they can reach the substrate 12. The ability to resist the space charge forces is dependent upon the kinetic energy of the charged particle, and the kinetic energy of the ionized cluster 30 is that of a single atom multiplied by the number of atoms in the cluster. Thus, the clusters 30 are able to penetrate to the surface 16 when individual, nonclustered atoms or ions could not.

When the ionized cluster 30 strikes the surface 16, it immediately disintegrates due to the low binding energy of each atom. Because the cluster is large and disintegrates readily into the individual atoms of the ionized species 32, its impact does not induce defects into the surface of the substrate 12. The atoms of the volatile species 32 act in the manner of a hot, energetic gas on the surface 16. These atoms strike and can dislodge contaminants that might reside on the surface 16, so that the contaminants leave the surface 16 and are removed from the vicinity of the surface 16 by the vacuum pumping system.

The atoms of the volatile species also strike the atoms of the nonvolatile species that are deposited from the vapor source 18, energizing these nonvolatile atoms by momentum transfer. The energized nonvolatile atoms are thereafter more readily mobile on the surface 16. If the impacted nonvolatile atom is already residing in a low energy location, such as a ledge, kink, or hole on the surface of the growing monolager, it is unlikely to move. However, if the impacted nonvolatile atom is in a relatively high energy site, the extra energy provided from the impact can activate the atom to move to a desirable low energy site. As a result of the activation of the nonvolatile atoms, the crystal structure of the film is more perfect and the incidence of intrinsic defect structures in the film is reduced. The resulting film is therefore more uniform, dense, and defect free, as compared with a conventionally grown film. The film has lower internal stress and strain, and adheres to the substrate more tightly.

After the atoms of the volatile species 32 have fulfilled their role of transferring energy to contaminants or to the nonvolatile atoms, they become essentially inert gas atoms at the surface 16. Since there is little or no binding force of these atoms to the surface 16, they leave the surface and are pumped away by the vacuum system.

The immediately preceding discussion referred to the use of inert or noble gases as the volatile species 32. A reactive species can also be used as the volatile species 32 in forming the clusters 30. Such a reactive species performs the same energy transfer role as does a noble gas, driving contaminants from the surface 16 and energizing the nonvolatile atoms. A reactive species is also chosen to be chemically reactive with the surface 16 or with the nonvolatile species, so that a reaction product is formed by the reaction with the reactive species. As an example, if the nonvolatile species is titanium and the volatile species is nitrogen, then the nitrogen clusters not only transfer energy to the surface but also provide nitrogen atoms to combine with the titanium to form titanium nitride at the surface 16. The titanium nitride is a new compound formed at the surface 16 by the reaction of two impacting species, and was not present apart from the surface or in one of the sources. The titanium nitride remains resident upon the surface 16 and becomes part of the growing film layer.

Even when the volatile species is chemically reactive so that a nonvolatile reaction product is formed, it is still proper to term the clusters 30 as volatile clusters. Typically, the number of cluster atoms reaching the surface is chosen to be about the same as the number of nonvolatile atoms reaching the surface. The clusters therefore typically contain about the number of stoichiometrically necessary volatile atoms required to react with the available nonvolatile atoms to form a compound.

The present approach using volatile clusters offers important advantages as compared with prior techniques using only nonvolatile clusters. The cluster forming efficiencies of nonvolatile materials are low, so that on the order of one percent of the nonvolatile atoms reach the surface of the substrate as clusters. The cluster forming efficiencies of volatile species are much higher, and may by as high as 50 percent. Where the cluster forming efficiency is low, a higher fraction of the nonvolatile material reaches the surface as ions with high energies per ion, with the result that the ions create point defects in the solid film as it is grown. The present approach largely avoids this problem. Another important advantage of utilizing volatile clusters in conjunction with the deposition of nonvolatile materials is that volatile clusters and nonvolatile material are directed toward the substrate from different, independently controllable sources. Consequently, the composition, size, charge and energy of the volatile clusters can be controlled as a growth apparatus parameter separate and independent from the composition and type of the source of the nonvolatile material. This added controllability is important, since some nonvolatile materials such as refractories of high melting point cannot be produced as clusters by known techniques. A separate volatile cluster source is required to achieve the benefits of the cluster approach in such circumstances. Finally, as has been discussed, with the volatile cluster technique, the volatile material can be reactive so that a new chemical compound is produced in a surface reaction on the substrate.

The present invention therefore adds a new and important capability for use in promoting the deposition of thin films onto substrates. Volatile clusters are directed against the surface of the substrate simultaneously with the deposition of a nonvolatile species, cleaning the surface and promoting uniformity of the film. Use of a reactive volatile species also permits formation of reaction products in chemical reactions in an energized surface environment. Although a particular embodiment of the invention has been described in detail for purposes of illustration, various modifications may be made without departing from the scope of the invention. Accordingly, the invention is not to be limited except as by the appended claims.

## Claims

1. A process for vapor depositing a film upon a substrate (12), comprising the steps of :
   depositing a nonvolatile material (24) upon the substrate (12) by vaporizing said material (24) using a vapor source (18) ; and, simultaneously, directing a beam (28) of ionized clusters (30) of a volatile species (32) against the substrate (12), each cluster (30) having from 2 to about 10000 atoms.

2. The process of claim 1, wherein the volatile species (32) is an inert gas, which does not react with the nonvolatile material (24).

3. The process of claim 1, wherein the volatile species (32) is a chemically active gas which does react with the nonvolatile material (24).

4. The process of claim 1, wherein each of the clusters (30) has from abot 1000 to about 10000 atoms.

5. The process of claim 1, wherein the clusters (30) are accelerated to an energy of from about 1 to about 5 electron volts per cluster atom.

6. The process of claim 1, wherein the nonvolatile material (24) is vaporized in a crucible and directed at the substrate (12).

7. The process of claim 1, wherein the volatile species (32) is selected from the group consisting of argon, oxygen, nitrogen, and an organic gaseous molecule.

8. The process of claim 1, wherein the beam (28) of the volatile species (32) is pulsed on and off repetitively.

9. The process of claim 1, wherein the deposition rate of volatile clusters (30) is such that about 1 volatile cluster atom reaches the substrate for each atom of the nonvolatile material (24) reaching the substrate.

10. The process of claim 1, wherein the substrate (12) is heated by means other than the energy carried by the nonvolatile material (24) and the volatile species (32).

11. Apparatus for vapor depositing a film upon a substrate (12) located in said apparatus (10), comprising :
    a vapor source (18) of a nonvolatile material (24) vapor disposed to deposit the nonvolatile material (24) onto the substrate (12) ; and

means for directing clusters (30) of a volatile species (32) against the substrate (12) simultaneously with vapor deposition from said vapor source (18), each cluster (30) having from 2 to about 10000 atoms.

12. The apparatus of claim 11, wherein said means for directing clusters (30) includes
    a source (34) of clusters of the volatile species (32),
    means (56) for ionizing the clusters (30), and
    means (62) for accelerating the clusters (30) toward the substrate (12).

13. The apparatus of claim 11, wherein said means for directing clusters includes a pulsed source (34) of the volatile clusters (30), said pulsed source (34) having the capability of a duty cycle of alternating emission of clusters and no emission of clusters.

14. The apparatus of claim 11, wherein said means for directing clusters includes a source (34) having a supersonic nozzle (40) for emitting the clusters (30) toward the substrate (12).

15. The apparatus of claim 11, wherein said vapor source is an electron-beam evaporator.

16. The apparatus of claim 12, wherein said means for directing clusters (30) operates continuously.

## Ansprüche

1. Verfahren zum Dampfabscheiden eines Filmes auf ein Substrat (12), welches die Schritte aufweist :
   Abscheiden eines nichtflüchtigen Materials (24) auf das Substrat (12) durch Verdampfen des Materials (24) unter Verwendung einer Dampfquelle (18) ; und gleichzeitig
   Richten eines Strahles (28) von ionisierten Clustern (30) einer flüchtigen Art (32) gegen das Substrat (12), wobei jeder Cluster (30) von 2 bis etwa 10000 Atome aufweist.

2. Verfahren nach Anspruch 1, dadurch gekennzeichnet, daß die flüchtige Art (32) ein Edelgas darstellt, welches nicht mit dem nichtflüchtigen Material (24) reagiert.

3. Verfahren nach Anspruch 1, dadurch gekennzeichnet, daß die flüchtige Art (32) ein chemisch aktives Gas darstellt, welches mit dem nichtflüchtigen Material (24) reagiert.

4. Verfahren nach Anspruch 1, dadurch gekennzeichnet, daß jeder von den Clustern (30) von etwa 1000 bis etwa 10000 Atome aufweist.

5. Verfahren nach Anspruch 1, dadurch gekennzeichnet, daß die Cluster (30) beschleunigt werden bis zu einer Energie von etwa 1 bis etwa 5 Elektronenvolt pro Clusteratom.

6. Verfahren nach Anspruch 1, dadurch gekennzeichnet, daß das nichtflüchtige Material (24) in einem Tiegel verdampft wird und auf das Substrat (12) gerichtet wird.

7. Verfahren nach Anspruch 1, dadurch gekennzeichnet, daß die flüchtige Art (32) aus der Gruppe bestehend aus Argon, Sauerstoff, Stickstoff, und einem organischen Gasmolekül ausgewählt wird.

8. Verfahren nach Anspruch 1, dadurch gekennzeichnet, daß der Strahl (28) der flüchtigen Art (32) jeweils ein- und auspulsiert wird.

9. Verfahren nach Anspruch 1, dadurch gekennzeichnet, daß die Abscheiderate der flüchtigen Cluster (30) derart ist, daß etwa ein flüchtiges Clusteratom das Substrat für jedes Atom des nichtflüchtigen Materials (24), welches das Substrat erreicht, erreicht.

10. Verfahren nach Anspruch 1, dadurch gekennzeichnet, daß das Substrat (12) aufgeheizt wird durch eine andere Maßnahme als die Energie, welche durch das nichtflüchtige Material (24) und die flüchtige Art (32) getragen ist.

11. Vorrichtung zum Dampfabscheiden eines Filmes auf ein Substrat (12), welches in der Vorrichtung (10) angeordnet ist, welche aufweist :

eine Dampfquelle (18) eines nichtflüchtigen Materials in Dampfform zum Abscheiden des nichtflüchtigen Materials (24) auf das Substrat (12) ; und

eine Einrichtung zum Richten von Clustern (30) einer flüchtigen Art (32) gegen das Substrat (12) gleichzeitig mit der Dampfabscheidung aus der Dampfquelle (18), wobei jeder Cluster (30) von 2 bis etwa 10000 Atome aufweist.

12. Vorrichtung nach Anspruch 11, dadurch gekennzeichnet, daß die Einrichtung zum Richten der Cluster (30) aufweist :

eine Quelle (34) der Cluster der flüchtigen Art (32),

eine Einrichtung (56) zum Ionisieren der Cluster (30), und

eine Einrichtung (62) zum Beschleunigen der Cluster (30) gegen das Substrat (12).

13. Vorrichtung nach Anspruch 11, dadurch gekennzeichnet, daß die Einrichtung zum Richten der Cluster eine gepulste Quelle (34) der flüchtigen Cluster (30) aufweist, wobei die gepulste Quelle (34) die Eigenschaft eines Tastverhältnisses von alternierender Emission von Clustern und keiner Emission von Clustern aufweist.

14. Vorrichtung nach Anspruch 11, dadurch gekennzeichnet, daß die Einrichtung zum Richten der Cluster eine Quelle (34) mit einer Überschalldüse (40) zum Emittieren der Cluster (30) gegen das Substrat (12) aufweist.

15. Vorrichtung nach Anspruch 11, dadurch gekennzeichnet, daß die Dampfquelle einen Elektronenstrahl-Verdampfer darstellt.

16. Vorrichtung nach Anspruch 12, dadurch gekennzeichnet, daß die Einrichtung zum Richten der Cluster (30) kontinuierlich betreibbar ist.

## Revendications

1. Procédé pour déposer en phase gazeuse un film sur un substrat (12), comportant les étapes suivantes :

on dépose un matériau non volatil (24) sur le substrat (12) en vaporisant ce matériau (24) en utilisant une source (18) de vapeur, et simultanément,

on dirige un faisceau (28) d'agrégats ionisés (30) d'une espèce volatile sur le substrat (12), chaque agrégat (30) comportant de 2 à environ 10000 atomes.

2. Procédé conforme à la revendication 1, dans lequel l'espèce volatile (32) est un gaz inerte qui ne réagit pas avec le matériau non volatil (24).

3. Procédé conforme à la revendication 1, dans lequel l'espèce volatile (32) est un gaz chimiquement actif qui réagit avec le matériau non volatil (24).

4. Procédé conforme à la revendication 1, dans lequel chacun des agrégats (30) comporte d'environ 1000 à environ 10000 atomes.

5. Procédé conforme à la revendication 1, dans lequel on accélère les agrégats (30) jusqu'à une énergie d'environ 1 à environ 5 électron-volts par atome d'agrégat.

6. Procédé conforme à la revendication 1, dans lequel on vaporise le matériau non volatil (24) dans un creuset et on le dirige sur le substrat (12).

7. Procédé conforme à la revendication 1, dans lequel l'espèce volatile (32) est choisie dans le groupe formé par l'argon, l'oxygène, l'azote et une molécule organique gazeuse.

8. Procédé conforme à la revendication 1, dans lequel le faisceau (28) de l'espèce volatile (32) est un faisceau intermittent par impulsions répétées.

9. Procédé conforme à la revendication 1, dans lequel le taux de dépôt d'agrégats volatils (30) est tel qu'environ un atome d'agrégat volatil atteint le substrat pour chaque atome de matériau non volatil (24) atteignant le substrat.

10. Procédé conforme à la revendication 1, dans lequel on chauffe le substrat (12) par les moyens autres que l'énergie apportée par le matériau non volatil (24) et l'espèce volatile (32).

11. Dispositif pour déposer en phase gazeuse un film sur un substrat (12) placé dans ce dispositif (10), comportant :

une source de vapeur (18) émettant une vapeur d'un matériau non-volatil (24) disposée de façon à déposer le matériau non-volatil (24) sur le substrat (12) ; et

des moyens pour diriger des agrégats (30) d'une espèce volatile (32) sur le substrat (12) en même temps que le dépôt en phase gazeuse depuis la source de vapeur (18), chaque agrégat (30) comportant de 2 à environ 10000 atomes.

12. Dispositif conforme à la revendication 11, dans lequel les moyens pour diriger des agrégats (30) comprennent :

une source (34) d'agrégats de l'espèce volatile (32),

des moyens (56) pour ioniser les agrégats (30), et

des moyens (62) pour accélérer les agrégats (30) en direction du substrat (12).

13. Dispositif conforme à la revendication 11, dans lequel les moyens pour diriger des agrégats comportent une source pulsée (34) émettant les agrégats volatils, cette source pulsée (34) étant capable d'avoir un cycle de fonctionnement consistant à alterner des périodes d'émission d'agrégats et des périodes sans émission d'agrégats.

14. Dispositif conforme à la revendication 11, dans lequel les moyens pour diriger des agrégats comprennent une source (34) comportant une tuyère supersonique (40) destinée à émettre les agrégats (30) vers le substrat (12).

15. Dispositif conforme à la revendication 11, dans lequel la source de vapeur est un évaporateur à faisceau d'électrons.

16. Dispositif conforme à la revendication 12, dans lequel les moyens pour diriger des agrégats (30) fonctionnent en continu.

FIG.1

FIG.2